# EUROPÄISCHE PATENTANMELDUNG

(11) **EP 4 734 672 A1**
(43) Veröffentlichungstag der Anmeldung: **29.04.2026**
(21) Anmeldenummer: 25209252.3
(22) Anmeldetag: 16.10.2025
(51) Int. Cl.: H05K 3/28, H05K 3/34

(54) **LEITERPLATTENANORDNUNG**

(30) Priorität: 22.10.2024 DE 102024130700
(71) Anmelder: Rolls-Royce Deutschland Ltd & Co KG, 15827 Blankenfelde-Mahlow (DE)
(72) Erfinder: WALTRICH, Uwe, 15827 Blankenfelde-Mahlow (DE); SCHAMBERGER, Niklas, 15827 Blankenfelde-Mahlow (DE); PATEL, Dipenkumar, 15827 Blankenfelde-Mahlow (DE)

(57) **Zusammenfassung**

Die Erfindung betrifft eine Leiterplattenanordnung, die aufweist: eine Leiterplatte (1) mit einer Oberseite (11) und einer Unterseite (12), und ein elektrisches Modul (2) mit einer Oberseite (21) und einer Unterseite (22), das mit seiner Oberseite (21) mit der Unterseite (12) der Leiterplatte (1) elektrisch verbunden ist, wobei zur elektrischen Kontaktierung des elektrischen Moduls (2) dieses auf seiner Oberseite (21) elektrische Kontakte (42, 426, 427, 428) aufweist, und wobei zwischen der Oberseite (21) des elektrischen Moduls (2) und der Unterseite (12) der Leiterplatte (1) im Bereich neben den elektrischen Kontakten (42, 426, 427, 428) ein Underfillmaterial (5) angeordnet ist. Es ist vorgesehen, dass die elektrischen Kontakte (42, 426, 427, 428) jeweils benachbart zu einem Seitenrand (211-214) der Oberseite (21) des elektrischen Moduls (2) angeordnet sind und ein Randspalt (7) zwischen dem jeweiligen elektrischen Kontakt (42, 426, 427, 428) und dem benachbarten Seitenrand (211-214) über ein Edgebondmaterial (8) verschlossen ist.

## Beschreibung

Die Erfindung betrifft eine Leiterplattenanordnung gemäß dem Oberbegriff des Patentanspruchs 1.

Es ist bekannt, leiterplattenbasierte Leistungselektronikbaugruppen als elektrische Module an der Unterseite einer Leiterplatte bzw. Schaltungsplatine anzuordnen. Dabei entsteht ein Spalt zwischen der Oberseite der elektrischen Module und der Leiterplatte, in dem hohe elektrische Feldstärken herrschen, die zu Oberflächen- oder Teilentladungen führen können, die wiederum zu einer Degradation des Leiterplattenmaterials führen können. Daher ist es weiter bekannt, ein Underfillmaterial in den Spalt zwischen dem elektrischen Modul und der Leiterplatte zu applizieren, um Teilentladungen zu vermeiden und Anforderungen an Luft- und Kriechstrecken einzuhalten.

Der entsprechende Underfillprozess umfasst das Applizieren einer definierten Menge eines Underfillmaterials entlang mindestens einer Seite des jeweiligen Moduls, wobei sich das Underfillmaterial durch Kapillarwirkung in den Spalt ausbreitet. Dabei besteht das Problem, dass sich beim Ausbreiten des Underfillmaterials Lufteinschlüsse bilden können, die wiederum zur Teilentladungen führen und die Gefahr eines frühzeitigen Isolationsversagens mit sich bringen. Damit bestehen ein erhöhter fertigungsbegleitender Kontrollaufwand und eine erhöhte Ausschussquote.

Der Erfindung liegt die Aufgabe zugrunde, eine Leiterplattenanordnung bereitzustellen, die die Gefahr der Entstehung von Luftblasen beim Underfillprozess reduziert.

Diese Aufgabe wird durch eine Leiterplattenanordnung mit den Merkmalen des Anspruchs 1 gelöst. Ausgestaltungen der Erfindung sind in den abhängigen Ansprüchen angegeben.

Danach betrachtet die Erfindung eine Leiterplattenanordnung, die eine Leiterplatte mit einer Oberseite und einer Unterseite und ein elektrisches Modul mit einer Oberseite und einer Unterseite, das mit seiner Oberseite mit der Unterseite der Leiterplatte elektrisch verbunden ist, aufweist. Dabei weist zur elektrischen Kontaktierung des elektrischen Moduls dieses auf seiner Oberseite elektrische Kontakte aufweist ist zwischen der Oberseite des elektrischen Moduls und der Unterseite der Leiterplatte im Bereich neben den elektrischen Kontakten ein Underfillmaterial angeordnet.

Es ist vorgesehen, dass die elektrischen Kontakte jeweils benachbart zu einem Seitenrand der Oberseite des elektrischen Moduls angeordnet sind und ein Randspalt zwischen dem jeweiligen elektrischen Kontakt und dem benachbarten Seitenrand über ein Edgebondmaterial verschlossen ist.

Unter Edgebondmaterial wird dabei ein elektrisch nicht leitfähiger Klebstoff verstanden, der an den Rändern der elektrischen Kontakte aufgetragen ist und den Bereich bis zur Seitenkante verschließt, so dass in diesem Bereich kein Underfillmaterial fließen kann. Darüber hinaus dient das Edgebondmaterial einem Schutz vor mechanischen Belastungen.

Der Erfindung liegt die Erkenntnis zugrunde, die zwischen dem elektrischen Modul und der Leiterplatte befindliche Luft beim Applikationsprozess typischerweise durch das Underfillmaterial verdrängt wird. Wenn sich das Underfillmaterial allerdings von mehreren Seiten um einen elektrischen Kontakt ausbreitet, kann der Fall entstehen, dass Fließfronten des Unterfillvolumens aufeinander treten. Die zwischen den Fließfronten befindliche Luft kann nicht ausweichen, da sie zwischen den Fließfronten gefangen ist.

Die erfindungsgemäße Lösung vermeidet solche Szenarien. Die Anordnung der elektrischen Kontakte benachbart zu einem Seitenrand und das gleichzeitige Verschließen eines Randspalts zwischen dem jeweiligen elektrischen Kontakt und dem Seitenrand durch ein Edgebondmaterial sorgt dafür, dass an der Seite des elektrischen Kontakts, der dem Seitenrand zugewandt ist, die Ausbreitung von Underfillmaterial blockiert ist. Die Anordnung des elektrischen Kontakts und des Edgebondmaterials sorgt also für ein Verschließen des Fließpfads des Underfillvolumens im Randbereich, so dass sich das Underfillmaterial nur entlang der anderen Seiten ausbreiten kann.

Die Erfindung ermöglicht damit für eine gerichtete Ausbreitung des Underfillmaterials im Spalt zwischen dem elektrischen Modul und der Leiterplatte mit nur einer Fließfront, wobei das Aufeinandertreffen von sich in entgegengesetzten Fließrichtungen ausbreitenden Fließfronten und ein damit verbundener Lufteinschluss verhindert werden. Insbesondere ist das Edgebondmaterial ein anderes Material als das Underfillmaterial. Insbesondere verschließt das Edgebondmaterial nur den Randspalt und/oder befindet sich nicht in anderen Bereichen an der Oberseite des elektrischen Moduls.

Ein in weiterer, mit der vorliegenden Erfindung verbundener Vorteil besteht darin, dass das Underfillmaterial aufgrund der einheitlichen Fließfront von nur von einer Seite appliziert werden braucht, so dass der Applikationsprozess vereinfacht wird.

Es wird darauf hingewiesen, dass in der verwendeten Terminologie die Seite der Leiterplatte, an der die elektrischen Module angeordnet sind, als Unterseite bezeichnet wird, unabhängig von der tatsächlichen räumlichen Orientierung der Leiterplatte und der elektrischen Module.

Eine Ausgestaltung der Erfindung sieht vor, dass die elektrischen Kontakte als Streifen bzw. streifenförmig ausgebildet sind, wobei die Streifen die gleiche räumliche Ausrichtung aufweisen. Die Ausbildung von Streifen befördert dabei die Ausbreitung des Underfillmaterials entlang einer einheitlichen Fließfront während des Applikationsprozesses.

Dabei kann vorgesehen sein, dass die Streifen die gleiche Breite und Länge besitzen, abweichend von einer traditionellen Ausbildung der elektrischen Kontakte, bei der beispielsweise Drain-Kontakte, Source-Kontakte und Gate-Kontakte jeweils eine andere Größe aufweisen. Weiter kann vorgesehen sein, dass benachbarte Streifen jeweils den gleichen Abstand zueinander aufweisen, so dass sich das Underfillmaterial zwischen den streifenförmigen Kontakten jeweils in einem gleichgroßen Strömungskanal ausbreitet, was die Ausbreitung des Underfillmaterials weiter homogenisiert.

Eine weitere Ausgestaltung sieht vor, dass die elektrischen Kontakte in dem Sinne versetzt zueinander angeordnet sind, dass einer der elektrischen Kontakte benachbart zu einem ersten Seitenrand der Oberseite des elektrischen Moduls angeordnet ist und mindestens ein benachbarter elektrischer Kontakt benachbart zu dem gegenüberliegenden Seitenrand der Oberseite des elektrischen Moduls angeordnet ist. Die insofern versetzte Anordnung der elektrischen Kontakte führt zu einer schlangenförmigen Spaltgeometrie, die die Ausbildung einer einzigen Fließfront weiter verbessert.

Eine weitere Ausgestaltung sieht vor, dass an der Oberseite des elektrischen Moduls drei elektrische Kontakte ausgebildet sind, insbesondere ein erster elektrischer Kontakt für einen Drain-Anschluss, ein zweiter elektrischer Kontakt für einen Source-Anschluss und ein dritter elektrischer Kontakt für einen Gate-Anschluss. Hierdurch kann die elektrische Kontaktierung eines Halbleiterbauelements erfolgen.

Die elektrische Kontakte sind beispielsweise als Lotpads ausgebildet, wobei zur elektrischen Verbindung der elektrischen Kontakte mit entsprechenden elektrischen Kontakten auf der Unterseite der Leiterplatte ein Lotmaterial (Lotballen) appliziert wird. Grundsätzlich kann jedoch auch vorgesehen sein, dass die elektrischen Kontakte über Sintern mit entsprechenden elektrischen Kontakten auf der Unterseite der Leiterplatte verbunden werden, beispielsweise über einen Silbersinterprozess.

Die elektrischen Kontakte von Leiterplatte und elektrischem Modul sind allgemein beispielsweise als Kontaktflächen aus Kupfer oder alternativ aus einem anderen Metall wie Aluminium oder Silber ausgebildet. Dabei kann vorgesehen sein, dass die Kontaktflächen aus Kupfer zusätzlich metallisiert sind, beispielsweise mit einer Gold- oder Silberschicht.

Eine Ausgestaltung der Erfindung sieht vor, dass die elektrischen Kontakte derart angeordnet sind, dass bei Applikation eines noch flüssigen Underfillmaterials dieses in nur einer Richtung den Spalt zwischen der Oberseite des elektrischen Moduls und der Unterseite der Leiterplatte füllt. Dabei kann zum einen vorgesehen sein, dass die elektrischen Kontakte derart angeordnet sind, dass bei der Applikation des noch flüssigen Underfillmaterial dieses in Richtung der Streifen den Spalt zwischen der Oberseite des elektrischen Moduls und der Unterseite der Leiterplatte füllt. Zum anderen kann vorgesehen sein, dass die elektrischen Kontakte derart angeordnet sind, dass bei der Applikation des noch flüssigen Underfillmaterial dieses quer zur Richtung der Streifen den Spalt zwischen der Oberseite des elektrischen Moduls und der Unterseite der Leiterplatte füllt. In diesem Fall schreitet die einzige Fließfront bei der Applikation schlangenförmig voran.

Gemäß einer weiteren Ausgestaltung sind die an der Unterseite der Leiterplatte angeordneten elektrischen Kontakte mit einer Anordnung ausgebildet, die der Anordnung der elektrischen Kontakte auf der Oberseite des elektrischen Moduls entspricht. Alternativ können die elektrische Kontakte an der Unterseite der Leiterplatte auch großflächiger als die elektrischen Kontakte an der Oberseite des elektrischen Moduls ausgebildet sein.

Das Edgebondmaterial kann grundsätzlich aus einem beliebigen geeigneten Material bestehen. In Ausführungsbeispielen besteht das Edgebondmaterial aus den Gruppen der Epoxidharze, Acrylharze, Polyurethane oder Silikone.

Die Leiterplattenanordnung weist typischerweise eine Mehrzahl einzelner elektrischer Module auf, die zusammen eine elektrische Schaltung wie beispielsweise einen Stromrichter realisieren.

Das elektrische Modul kann grundsätzlich nach einer Vielzahl von Aufbauprinzipien realisiert sein. Eine Ausgestaltung hierzu sieht vor, dass das elektrische Modul umfasst:
- einen keramischen Schaltungsträger, der eine isolierende Keramikschicht und eine auf der Oberseite der Keramikschicht angeordnete obere Metallisierungsschicht aufweist, und
- ein elektrisches Bauelement, das auf dem keramischen Schaltungsträger angeordnet ist,
- wobei das elektrische Bauelement über die oberen elektrischen Kontakte des elektrischen Moduls und von diesen ausgehende Durchkontaktierungen elektrisch kontaktiert wird.

Dabei kann an der Unterseite der Keramikschicht eine weitere, untere Metallisierungsschicht angeordnet sein, die eine thermische Schnittstelle des elektrischen Moduls zu einem Kühlkörper bildet.

Bei einer solchen Ausgestaltung dient der keramische Schaltungsträger der elektrischen Isolation des elektrischen Bauelements zu einem Kühlkörper und gleichzeitig der thermischen Anbindung an den Kühlkörper. Bei dem elektrischen Bauelement handelt es sich beispielsweise um einen Leistungshalbleiter wie z.B. einen Leistungs-MOSFETs oder ein IGBT-Bauteil. Der keramische Schaltungsträger bildet zusammen mit dem Halbleiterbauelement und einer Umhüllung z.B. aus einem Vergussmaterial oder einem Leiterplattenmaterial das elektrisches Modul. Dieses ist über die oberen elektrischen Kontakte mit der Leiterplatte verbunden. Ein solches elektrisches Modul wird auch als Prepackage-Modul bezeichnet.

Die Erfindung wird nachfolgend unter Bezugnahme auf die Figuren der Zeichnung anhand mehrerer Ausführungsbeispiele näher erläutert. Es zeigen:
- Figur 1: ein Ausführungsbeispiel einer Leiterplattenanordnung mit einer Leiterplatte und einem an der Unterseite der Leiterplatte angeordneten elektrischen Modul, wobei in einem Spalt zwischen der Oberseite des elektrischen Moduls und der Unterseite der Leiterplatte ein Underfillmaterial angeordnet ist, und wobei die Oberseite des elektrischen Moduls eine Mehrzahl elektrischer Kontakte aufweist;
- Figur 2: beispielhaft Lufteinschlüsse im Underfillmaterial einer Leiterplattenanordnung gemäß Figur 1, die durch entgegengesetzte Fließfronten entstehen;
- Figur 3: ein Ausführungsbeispiel der Anordnung von elektrischen Kontakten auf der Oberseite eines elektrischen Moduls gemäß der Figur 1;
- Figur 4: das Ausführungsbeispiel der Figur 3, wobei zusätzlich ein Randspalt zwischen dem jeweiligen elektrischen Kontakt und dem benachbarten Seitenrand mit einem Edgebondmaterial verschlossen ist.

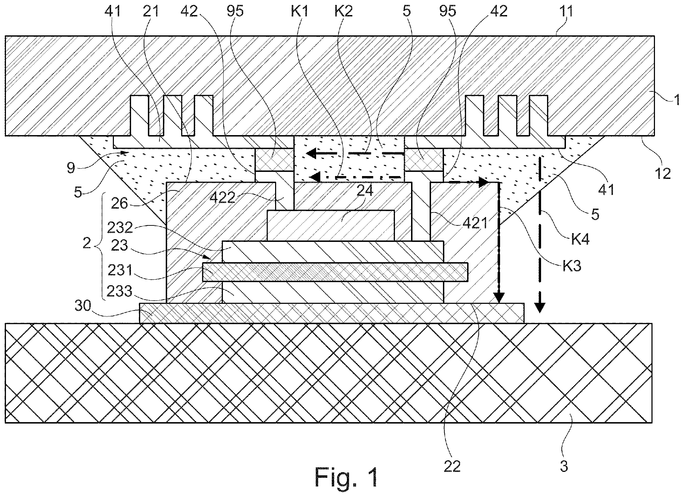

Die Figur 1 zeigt allgemein eine Leiterplattenanordnung, in der die vorliegende Erfindung realisiert werden kann.

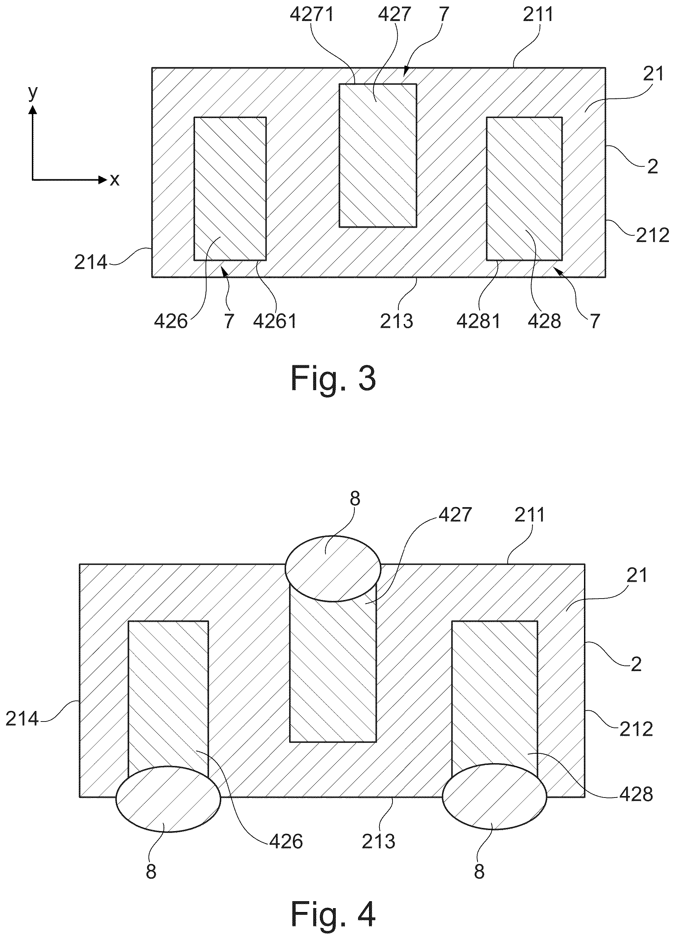

Die Leiterplattenanordnung 1 der Figur 4 umfasst eine Leiterplatte 1, ein elektrisches Modul 2 und optional einen Kühlkörper 3. Die Leiterplatte 1 ist mehrlagig ausgebildet und bildet beispielsweise eine Trägerplatine, auf der eine Vielzahl von elektrischen Modulen 2 und weitere Komponenten angeordnet sind. Die Leiterplatte 1 bildet eine Oberseite 11 und eine Unterseite 12 aus. An der Unterseite 12 ist eine Mehrzahl von elektrischen Kontakten 41 ausgebildet, die jeweils mit einem definierten Potenzial, beispielsweise einem Hochvoltpotenzial beaufschlagt sind. Bei den elektrischen Kontakten 41 handelt es sich beispielsweise um Kupferflächen.

Das elektrische Modul 2 umfasst einen keramischen Schaltungsträger 23 und ein elektrisches Bauelement 24. Der keramischen Schaltungsträger 23 umfasst eine isolierende Keramikschicht 231, eine auf der Oberseite der Keramikschicht 231 angeordnete obere Metallisierungsschicht 232 und eine optionale, auf der Unterseite der Keramikschicht 231 angeordnete untere Metallisierungsschicht 233. Auf der oberen Metallisierungsschicht 232 ist das elektrische Bauelement 24 angeordnet. Der keramische Schaltungsträger 23 und das elektrische Bauelement 24 sind in einem Substrat 26 angeordnet, das die Außenmaße des elektrischen Moduls 2 definiert. Bei dem Substrat 26 handelt es beispielsweise um ein Vergussmaterial oder ein Leiterplattenmaterial, in das der keramischen Schaltungsträger und das elektrische Modul eingebettet sind.

Die Oberseite 21 des elektrischen Moduls 2 weist eine Mehrzahl von elektrischen Kontakten 42, die beispielsweise durch Kupferflächen gebildet sind. Die Oberseite 21 des elektrischen Moduls 2 ist über eine Oberflächenmontage auf die Leiterplatte 2 gelötet, wobei die Kontaktflächen 42 des elektrischen Moduls 2 mit den entsprechenden Kontaktflächen 41 der Leiterplatte 1 über Lotverbindungen 95 elektrisch verbunden sind. Dabei bildet sich neben bzw. seitlich der Lotverbindungen 95 notwendigerweise ein Spalt 9 zwischen der Oberseite 21 des elektrischen Moduls 2 und der Unterseite 12 der Leiterplatte 1 aus. Dieser Spalt 9 ist durch ein Underfillmaterial 5 gefüllt. Das Underfillmaterial 5 wird im Rahmen eines Underfillprozesses appliziert, bei dem eine definierte Menge eines Underfillmaterials entlang mindestens einer Kante des Moduls 2 appliziert wird, wobei sich das Underfillmaterial durch Kapillarwirkung in den Spalt 9 ausbreitet.

Weiter umfassen die elektrischen Kontakte Durchkontaktierungen 421, die sich von einigen der elektrischen Kontaktflächen 42 zur oberen Metallisierungsschicht 233 des keramischen Schaltungsträgers 23 erstrecken, sowie Durchkontaktierungen 422, die sich von anderen der elektrischen Kontaktflächen 42 zur oberen Metallisierungsschicht 232 erstrecken. Über diese Durchkontaktierungen 421, 422 werden ein Unterseitenpotenzial und Oberseitenpotenziale des elektrischen Bauelements 24 bereitgestellt. Beispielsweise stellen die Durchkontaktierungen 421, 422 einen Source-Anschluss, einen Gate-Anschluss und einen Drain-Anschluss des elektrischen Bauelements 24 bereit.

Die Unterseite des elektrischen Moduls 2, die durch die untere Metallisierungsschicht 233 gebildet ist, ist über ein thermisches Schnittstellenmaterial 30, beispielsweise eine Wärmeleitmatte, thermisch an den Kühlkörper 3 angekoppelt. Der keramische Schaltungsträger 23 mit der Keramikschicht 231 dient zum einen der elektrischen Isolation des auf dem keramischen Schaltungsträger 23 angeordneten elektrischen Bauelements 24 zum Kühlkörper 3 und stellt gleichzeitig eine thermische Anbindung zum Kühlkörper 3 bereit.

Das elektrische Bauelement 24 ist beispielsweise ein Leistungshalbleiter und kann als integrierter Schaltkreis (Chip) ausgebildet sein.

Bei einem derartigen Aufbau sind hohe Anforderungen an Luft- und Kriechstrecken zu realisieren. Dies hängt damit zusammen, dass typischerweise ein Hochvoltpotenzial beispielsweise im Bereich von 1000 V an die Kontaktflächen 41, 42 angelegt ist. Somit existiert ein starkes elektrisches Feld zwischen den Kontaktflächen und dem typischerweise auf Masse gelegten Kühlkörper 3. Entsprechende potenzielle Kriechstrecken K1, K3 und Luftstrecken K2, K4 sind in der Figur 4 eingezeichnet.

Für eine Verbesserung der Isolationseigenschaften und eine Vermeidung von Teilentladungen ist bei einer Leiterplattenanordnung gemäß der Figur 1 wie erläutert vorgesehen, dass ein Underfillmaterial 5 im Spalt 9 zwischen der Unterseite 12 der Leiterplatte 1 und der Oberseite 21 des elektrischen Moduls 2 ausgebildet ist.

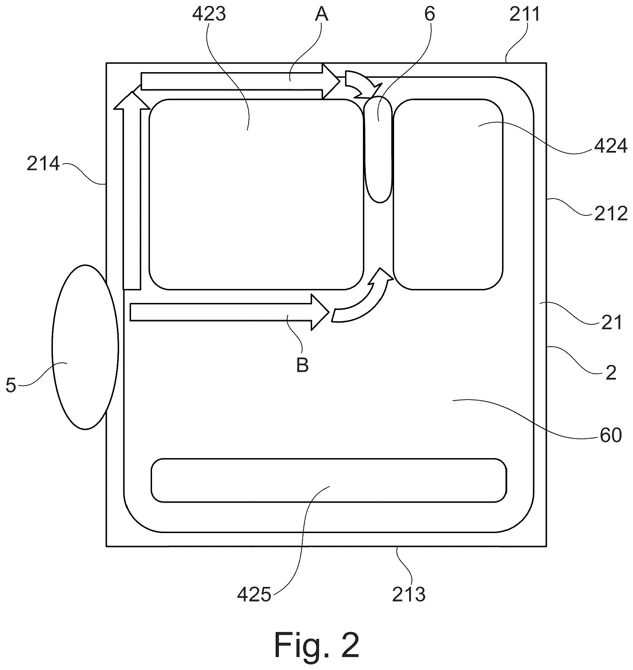

Bei der Applikation eines Underfillmaterials 5 im Spalt 9 können sich jedoch Lufteinschlüsse ergeben. Dies ist beispielhaft in der Figur 2 dargestellt. Die Figur 2 zeigt eine Draufsicht auf die Oberseite 21 eines elektrischen Moduls 2. Das elektrische Modul 2 ist rechteckig ausgebildet und weist dementsprechend einen oberen Seitenrand 211, einen unteren Seitenrand 213 und zwei seitliche Seitenränder 212, 214 auf. Die Seitenränder können auch als Seitenkanten bezeichnet werden.

Auf der Oberseite 21 des elektrischen Moduls 2 sind drei elektrische Kontakte angeordnet, nämlich ein Source-Kontakt 423, ein Gate-Kontakt 424 und ein Drain-Kontakt 425. Wenn nun zur Füllung des Spaltes 9 ein Underfillmaterial 5 an der einen Seitenkanten 214 des elektrischen Moduls 2 bereitgestellt wird, so breitet sich dieses im Zwischenraum bzw. Spalt 9 zwischen der Oberseite 21 des elektrischen Moduls 2 und der Unterseite 12 der Leiterplatte aus. In Bereichen wie dem Bereich 60 erfolgt dies unproblematisch, da eine einheitliche Fließrichtung des Underfillmaterials 5 vorliegt. Dagegen kann es zu Lufteinschlüssen 6 kommen, wenn das Underfillmaterial 5 zwei Fließfronten bildet, die in entgegengesetzter Richtung strömen. Dieses der Fall in dem Zwischenraum zwischen dem elektrischen Source-Kontakt 423 und dem elektrischen Gate-Kontakt 424. Hier treffen zum einen die Fließfront A und die Fließfront B aufeinander, so dass Luft 6 nicht entweichen kann und sich ein Lufteinschluss bildet.

Zur Vermeidung der in der Figur 2 erläuterten Situation sieht die vorliegende Erfindung eine Anordnung der elektrischen Kontakte gemäß den Figuren 3 und 4 vor.

Gemäß der Figur 3 befinden sich auf der Oberseite 21 des elektrischen Moduls 2, das wiederum vier Seitenränder 211, 212, 213 und 214 aufweist, drei elektrische Kontakte 426, 427, 428, die derart angeordnet sind, dass sie jeweils benachbart zu einem der Seitenränder, vorliegend der Seitenränder 211 oder 213 angeordnet sind. So befindet sich ein elektrischer Drain-Kontakt 426 benachbart zum Seitenrand 213, ein elektrischer Source-Kontakt 427 befindet sich benachbart zum Seitenrand 211 und ein elektrischer Gate-Kontakt 428 befindet sich benachbart zum Seitenrand 413.

Die Anordnung benachbart zu einem Seitenrand 211, 213 bedeutet dabei, dass sich lediglich ein kleiner Randspalt 7 zwischen der dem Seitenrand nächstliegenden Seitenkante des elektrischen Kontakts 426-428 und dem Seitenrand befindet. So befindet sich ein Randspalt 7 zwischen der Seitenkante 4261 und dem Seitenrand 213, ein Randspalt 7 zwischen der Seitenkante 4271 und dem Seitenrand 211 sowie ein Randspalt 7 zwischen der Seitenkante 4281 und dem Seitenrand 213.

Dabei ist gemäß der Figur 4 weiter vorgesehen, dass die genannten Randspalte 7 zwischen dem jeweiligen elektrischen Kontakt 426-428 und dem jeweiligen Seitenrand über ein Edgebondmaterial 8 verschlossen sind. Ein solches Edgebondmaterial ist in der Figur 4 schematisch eingezeichnet. Es handelt sich beispielsweise um ein Epoxidharz, ein Acrylharz, ein Polyurethan oder ein Silikon.

Die weitere Beschreibung bezieht sich gleichermaßen auf die Figuren 3 und 4. Die elektrischen Kontakte 426, 427, 428 sind jeweils streifenförmig ausgebildet, d. h. sie sind rechteckig und weisen eine größere Länge (in y-Richtung) als Breite (in x-Richtung) auf, wobei die x-Richtung und die y-Richtung in der Figur 3 eingezeichnet sind. Dabei besitzen die elektrischen Kontakte 426, 427, 428 alle die gleiche Breite und Länge. Auch weisen Sie den gleichen Abstand zueinander auf.

Weiter sind die elektrischen Kontakte 426, 427, 428 in dem Sinne versetzt zueinander angeordnet, dass die elektrischen Kontakte 426, 428 benachbart zum unteren Seitenrand 213 und der elektrische Kontakt 427 benachbart zum oberen Seitenrand 211 angeordnet ist.

Die beschriebene Anordnung der elektrischen Kontakte 426, 427, 428 erlaubt es, den in der Figur 1 dargestellten Spalt 9 zwischen der Oberseite 21 des elektrischen Moduls 1 und der Unterseite 12 der Leiterplatte 1 im Applikationsprozess mit einer einzigen Fließfront zu füllen, so dass das Risiko von Lufteinschlüssen minimiert wird. Dies wird durch die beschriebene Spaltgeometrie erreicht, bei der keine Fließfronten aufeinandertreffen können.

So kann vorgesehen sein, dass das Underfillmaterial an der oberen Kante 211 oder der unteren Kante 213 appliziert wird. Es breitet sich bei einer Applikation an der oberen Kante 211 mit einer Fließfront von der oberen Kante 211 zur unteren Kante 212 aus. Da die jeweiligen Randbereiche der elektrischen Kontakte 426, 427, 428 zum benachbarten Seitenrand 211, 213 durch das Edgebondmaterial 8 verschlossen sind, können dort keine entgegengesetzten Fließfronten aufeinandertreffen. Entsprechend breitet sich das Underfillmaterial bei einer Applikation an der unteren Kante 213 von unten nach oben aus.

Alternativ kann vorgesehen sein, dass das Underfillmaterial an einer der Seitenkanten 214, 212 appliziert wird. Für diesen Fall ergibt sich ein schlangenförmiger Verlauf der Fließfront. Bei einer Applikation beispielsweise an der linken Seitenkante 214 breitet sich das Underfillmaterial Fall erst im Kanal zwischen den elektrischen Kontakten 426, 427, dann um das untere Ende des elektrischen Kontakts 427 und dann im Kanal zwischen den elektrischen Kontakten 427, 428 aus. Auch in diesem Fall liegt jedoch nur eine einzige Fließfront vor und besteht nicht die Gefahr, dass sich entgegengesetzte Fließfronten treffen.

Es versteht sich, dass die Erfindung nicht auf die oben beschriebenen Ausführungsformen beschränkt ist und verschiedene Modifikationen und Verbesserungen vorgenommen werden können, ohne von den hier beschriebenen Konzepten abzuweichen. Weiter wird darauf hingewiesen, dass beliebige der beschriebenen Merkmale separat oder in Kombination mit beliebigen anderen Merkmalen eingesetzt werden können, sofern sie sich nicht gegenseitig ausschließen. Die Offenbarung dehnt sich auf alle Kombinationen und Unterkombinationen eines oder mehrerer Merkmale aus, die hier beschrieben werden und umfasst diese. Sofern Bereiche definiert sind, so umfassen diese sämtliche Werte innerhalb dieser Bereiche sowie sämtliche Teilbereiche, die in einen Bereich fallen.

## Patentansprüche

1. Leiterplattenanordnung, die aufweist:
- eine Leiterplatte (1) mit einer Oberseite (11) und einer Unterseite (12), und
- ein elektrisches Modul (2) mit einer Oberseite (21) und einer Unterseite (22), das mit seiner Oberseite (21) mit der Unterseite (12) der Leiterplatte (1) elektrisch verbunden ist,
- wobei zur elektrischen Kontaktierung des elektrischen Moduls (2) dieses auf seiner Oberseite (21) elektrische Kontakte (42, 426, 427, 428) aufweist, und
- wobei zwischen der Oberseite (21) des elektrischen Moduls (2) und der Unterseite (12) der Leiterplatte (1) im Bereich neben den elektrischen Kontakten (42, 426, 427, 428) ein Underfillmaterial (5) angeordnet ist,
**dadurch gekennzeichnet,**
**dass** die elektrischen Kontakte (42, 426, 427, 428) jeweils benachbart zu einem Seitenrand (211-214) der Oberseite (21) des elektrischen Moduls (2) angeordnet sind und ein Randspalt (7) zwischen dem jeweiligen elektrischen Kontakt (42, 426, 427, 428) und dem benachbarten Seitenrand (211-214) über ein Edgebondmaterial (8) verschlossen ist.

2. Leiterplattenanordnung nach Anspruch 1, **dadurch gekennzeichnet, dass** die elektrischen Kontakte (426, 427, 428) als Streifen ausgebildet sind, wobei die Streifen die gleiche räumliche Ausrichtung aufweisen.

3. Leiterplattenanordnung nach Anspruch 2, **dadurch gekennzeichnet, dass** die Streifen (426, 427, 428) die gleiche Breite und Länge besitzen.

4. Leiterplattenanordnung nach Anspruch 2 oder 3, **dadurch gekennzeichnet, dass** benachbarte Streifen (426, 427, 428) jeweils den gleichen Abstand zueinander aufweisen.

5. Leiterplattenanordnung nach einem der vorangehenden Ansprüche, **dadurch gekennzeichnet, dass** die elektrischen Kontakte (426, 427, 428) in dem Sinne versetzt zueinander angeordnet sind, dass einer der elektrischen Kontakte (427) benachbart zu einem ersten Seitenrand (211) der Oberseite (21) des elektrischen Moduls (2) angeordnet ist und mindestens ein benachbarter elektrischer Kontakt (426, 428) benachbart zu dem gegenüberliegenden Seitenrand (213) der Oberseite (21) des elektrischen Moduls (2) angeordnet ist.

6. Leiterplattenanordnung nach einem der vorangehenden Ansprüche, **dadurch gekennzeichnet, dass** an der Oberseite (21) des elektrischen Moduls (2) drei elektrische Kontakte (426, 427, 428) ausgebildet sind.

7. Leiterplattenanordnung nach Anspruch 6, **dadurch gekennzeichnet, dass** auf der Oberseite (21) des elektrischen Moduls (2) ein erster elektrischer Kontakt (426) für einen Drain-Anschluss, ein zweiter elektrischer Kontakt (427) für einen Source-Anschluss und ein dritter elektrischer Kontakt (428) für einen Gate-Anschluss angeordnet sind.

8. Leiterplattenanordnung nach einem der vorangehenden Ansprüche, **dadurch gekennzeichnet, dass** die elektrischen Kontakte (42, 426, 427, 428) als Lotpads ausgebildet sind.

9. Leiterplattenanordnung nach einem der vorangehenden Ansprüche, **dadurch gekennzeichnet, dass** die elektrischen Kontakte (426, 427, 428) derart angeordnet sind, dass bei Applikation eines noch flüssigen Underfillmaterials (5) dieses in nur einer Richtung den Spalt (9) zwischen der Oberseite (21) des elektrischen Moduls (2) und der Unterseite (12) der Leiterplatte (1) füllt.

10. Leiterplattenanordnung nach Anspruch 9, soweit rückbezogen nach Anspruch 2, **dadurch gekennzeichnet, dass** die elektrischen Kontakte (426, 427, 428) derart angeordnet sind, dass bei Applikation des noch flüssigen Underfillmaterials (5) dieses in Richtung der Streifen (y) den Spalt (9) zwischen der Oberseite (21) des elektrischen Moduls (2) und der Unterseite (12) der Leiterplatte (1) füllt.

11. Leiterplattenanordnung nach Anspruch 9, soweit rückbezogen nach Anspruch 2, **dadurch gekennzeichnet, dass** die elektrischen Kontakte (426, 427, 428) derart angeordnet sind, dass bei Applikation des noch flüssigen Underfillmaterials (5) dieses quer zur Richtung der Streifen (x) den Spalt (9) zwischen der Oberseite (21) des elektrischen Moduls (2) und der Unterseite (12) der Leiterplatte (1) füllt.

12. Leiterplattenanordnung nach einem der vorangehenden Ansprüche, **dadurch gekennzeichnet, dass** an der Unterseite (12) der Leiterplatte (1) elektrische Kontakte (41) mit einer Anordnung ausgebildet sind, die der Anordnung der elektrischen Kontakte (42, 426, 427, 428) auf der Oberseite (21) des elektrischen Moduls (2) entspricht.

13. Leiterplattenanordnung nach einem der vorangehenden Ansprüche, **dadurch gekennzeichnet, dass** das Edgebondmaterial (8) durch ein Epoxidharz, ein Acrylharz, ein Polyurethan oder ein Silikon gebildet ist.

14. Leiterplattenanordnung nach einem der vorangehenden Ansprüche, **dadurch gekennzeichnet, dass** das elektrische Modul (2) umfasst:
- einen keramischen Schaltungsträger (23), der eine isolierende Keramikschicht (231) und eine auf der Oberseite der Keramikschicht (231) angeordnete obere Metallisierungsschicht (232) aufweist, und
- ein elektrisches Bauelement (24), das auf dem keramischen Schaltungsträger (23) angeordnet ist,
- wobei das elektrische Bauelement (24) über die elektrischen Kontakte (42, 426, 427, 428) des elektrischen Moduls (2) und von diesen ausgehende Durchkontaktierungen (421, 422) elektrisch kontaktiert wird.

15. Leiterplattenanordnung nach einem der vorangehenden Ansprüche, **dadurch gekennzeichnet, dass**
- das Edgebondmaterial (8) ein anderes Material als das Underfillmaterial (5) ist, und
- das Edgebondmaterial (8) nur den Randspalt (7) verschließt und sich nicht in anderen Bereichen an der Oberseite (21) des elektrischen Moduls (2) befindet.
